# EUROPÄISCHE PATENTSCHRIFT

(11) **EP 3 564 911 B1**
(45) Veröffentlichungstag und Bekanntmachung des Hinweises auf die Patenterteilung: **19.10.2022**
(21) Anmeldenummer: 18170891.8
(22) Anmeldetag: 04.05.2018
(51) Int. Cl.: G07C 3/00, H01M 10/42, H01M 10/44, H01M 10/48

(54) **EINRICHTUNG ZUR ERFASSUNG VON BETRIEBSDATEN EINES MOTORANGETRIEBENEN WERKZEUGS UND SYSTEM**
DEVICE FOR DETECTING OPERATING DATA OF A MOTORISED TOOL AND SYSTEM
DISPOSITIF DE DÉTECTION DE DONNÉES DE FONCTIONNEMENT D'UN OUTIL MOTORISÉ ET SYSTÈME

(43) Veröffentlichungstag der Anmeldung: 06.11.2019
(73) Patentinhaber: Andreas Stihl AG & Co. KG, 71336 Waiblingen (DE)
(72) Erfinder: Gurr, Kay-Steffen, 74078 Heilbronn (DE); Vaas, André, 73489 Jagstzell (DE)
(74) Vertreter: Patentanwälte Ruff, Wilhelm, Beier, Dauster & Partner mbB

(56) Entgegenhaltungen:
- EP-A1- 2 477 270
- EP-A1- 3 291 181
- EP-A2- 1 708 335

## Beschreibung

### ANWENDUNGSGEBIET UND STAND DER TECHNIK

Die Erfindung betrifft eine Einrichtung zur Erfassung von Betriebsdaten eines motorangetriebenen Werkzeugs und ein System mit einer solchen Einrichtung und einem motorangetriebenen Werkzeug.

Die EP 3 291 181 A1 offenbart ein Gerät zur Erfassung von Betriebsdaten eines Werkzeugs. Das Werkzeug ist mittels eines Elektromotors oder eines Verbrennungsmotors angetrieben. Das Gerät ist getrennt von dem Werkzeug ausgebildet und mit dem Werkzeug koppelbar. Das Gerät weist einen Sensor, eine mit dem Sensor gekoppelte Auswerteeinrichtung, einen Betriebsdatenspeicher, eine Kommunikationsschnittstelle und einen elektrischen Energiespeicher auf. Der Sensor ist dazu ausgebildet, drahtlos mindestens eine Messgröße zu erfassen. Die Messgröße ist von einem Betriebszustand des Werkzeugs abhängig. Die Auswerteeinrichtung ist dazu ausgebildet, die mittels des Sensors erfasste Messgröße auszuwerten, um daraus die Betriebsdaten zu ermitteln. Der Betriebsdatenspeicher ist dazu ausgebildet, die Betriebsdaten zu speichern. Die Kommunikationsschnittstelle ist dazu ausgebildet, im Betriebsdatenspeicher gespeicherte Betriebsdaten drahtlos zu einem Endgerät zu übertragen.

Die EP 2 477 270 A1 offenbart ein Lade/Entladesystem aufweisend eine Entladekontrollsektion zum Kontrollieren eines Entladens einer Lithiumsekundärbatterie und eine Spannungsmessungssektion zum Messen eines Potentials der Batterie während des Entladens der Batterie. Wenn das Potential ein vorbestimmtes Entladepotential erreicht, stoppt bzw. beendet die Entladekontrollsektion das Entladen. Des Weiteren weist das Lade/Entladesystem Entladeendpotentialschaltmittel zum Schalten des Entladeendpotentials auf. Die Entladeendpotentialschaltmittel sind zum Schalten des Entladeendpotentials zwischen einem ersten Potential und einem zweiten Potential, das niedriger als das erste Potential ist, fähig. Außerdem weist die Batterie eine Temperaturmessungssektion zum Messen einer Batterietemperatur während des Entladens auf. Wenn die detektierte Batterietemperatur höher als eine vorbestimmte Temperatur ist, wird das Entladeendpotential auf das erste Potential gesetzt. Wenn die detektierte Batterietemperatur gleich oder niedriger als die vorbestimmte Temperatur ist, wird das Entladeendpotential auf das zweite Potential gesetzt.

Die EP 1 708 335 A2 offenbart eine elektrische Vorrichtung mit einem Batteriepack.

### AUFGABE UND LÖSUNG

Der Erfindung liegt als Aufgabe die Bereitstellung einer Einrichtung zur Erfassung von Betriebsdaten eines motorangetriebenen Werkzeugs, die zuverlässig ist, und eines Systems mit einer solchen Einrichtung und einem motorangetriebenen Werkzeug zugrunde.

Die Erfindung löst diese Aufgabe durch die Bereitstellung einer Einrichtung mit den Merkmalen des Anspruchs 1 und eines Systems mit den Merkmalen des Anspruchs 14. Vorteilhafte Weiterbildungen und/oder Ausgestaltungen der Erfindung sind in den abhängigen Ansprüchen beschrieben.

Die erfindungsgemäße Einrichtung zur Erfassung von Betriebsdaten eines motorangetriebenen Werkzeugs ist zur Anordnung an, insbesondere in, dem Werkzeug ausgebildet. Die Einrichtung weist eine, insbesondere elektrische, Erfassungs- und/oder Auswerteeinrichtung auf. Die Erfassungs- und/oder Auswerteeinrichtung ist dazu ausgebildet, mindestens eine, insbesondere physikalische, Größe, insbesondere einen Wert beziehungsweise einen Betrag der Größe, zu erfassen, wobei die Größe, insbesondere ihr Wert, von einem Betriebszustand des Werkzeugs abhängig ist, und die erfasste Größe, insbesondere ihren Wert, zur Ermittlung der Betriebsdaten auszuwerten, insbesondere automatisch. Zusätzlich oder alternativ ist die Erfassungs- und/oder Auswerteeinrichtung dazu ausgebildet, Betriebsdaten zu erfassen, insbesondere automatisch. Des Weiteren weist die Einrichtung einen, insbesondere elektrischen, Betriebsdatenspeicher und/oder eine, insbesondere elektrische, Kommunikationsschnittstelle auf. Der Betriebsdatenspeicher ist dazu ausgebildet, die ermittelten und/oder erfassten Betriebsdaten zu speichern, insbesondere automatisch. Die Kommunikationsschnittstelle ist dazu ausgebildet, die, insbesondere gespeicherten, Betriebsdaten drahtlos zu einem Endgerät zu übertragen beziehungsweise zu senden, insbesondere automatisch. Die Erfassungs- und/oder Auswerteeinrichtung, der Betriebsdatenspeicher und/oder die Kommunikationsschnittstelle sind/ist dazu ausgebildet, im, insbesondere jeweiligen, Betrieb einem elektrochemischen Energiespeicher, insbesondere einer Batterie, elektrische Leistung zu entnehmen beziehungsweise mit elektrischer Leistung von dem elektrochemischen Energiespeicher, insbesondere der Batterie, versorgt zu werden, insbesondere automatisch. Außerdem weist die Einrichtung eine, insbesondere elektrische, Betriebsmodussteuerungseinrichtung auf. Die Betriebsmodussteuerungseinrichtung ist dazu ausgebildet, die Erfassungs- und/oder Auswerteeinrichtung, den Betriebsdatenspeicher und/oder die Kommunikationsschnittstelle bei einer Temperatur, insbesondere einem Wert beziehungsweise einem Betrag der Temperatur, oberhalb von einem, insbesondere jeweiligen, Temperaturgrenzwert in einem, insbesondere jeweiligen, Normaltemperaturbetriebsmodus und bei einer Temperatur, insbesondere einem Wert beziehungsweise einem Betrag der Temperatur, gleich oder unterhalb des Temperaturgrenzwerts in einem, insbesondere jeweiligen, von dem Normaltemperaturbetriebsmodus verschiedenen Tieftemperaturbetriebsmodus derart zu betreiben, insbesondere automatisch, dass im Tieftemperaturbetriebsmodus dem elektrochemischen Energiespeicher, insbesondere der Batterie, insbesondere von der Erfassungs- und/oder Auswerteeinrichtung, dem Betriebsdatenspeicher und/oder der Kommunikationsschnittstelle, weniger elektrische Leistung als im Normaltemperaturbetriebsmodus entnommen wird.

Die Einrichtung beziehungsweise ihre Erfassungs- und/oder Auswerteeinrichtung, ihr Betriebsdatenspeicher und/oder ihre Kommunikationsschnittstelle ermöglichen die Betriebsdaten zu erfassen, zu speichern und/oder zu übertragen.

Des Weiteren ermöglicht die Einrichtung beziehungsweise ihre Betriebsmodussteuerungseinrichtung, insbesondere der Tieftemperaturbetriebsmodus, einen schonenden Betrieb des elektrochemischen Energiespeichers, insbesondere der Batterie, somit einen zeitlich relativ langen Betrieb mit dem elektrochemischen Energiespeicher, insbesondere der Batterie, und somit einen zuverlässigen Betrieb, insbesondere bei einer tiefen Temperatur.

Im Detail kann mit sinkender Temperatur ein Widerstand, insbesondere ein Innenwiderstand, des elektrochemischen Energiespeichers, insbesondere der Batterie, sich erhöhen beziehungsweise steigen. Somit kann mit sinkender Temperatur eine, insbesondere schädigungsfrei, entnehmbare Leistung des elektrochemischen Energiespeichers sinken. Eine zu hohe Leistungsentnahme kann zu irreversiblen Prozessen in dem elektrochemischen Energiespeicher und somit zu einer dauerhaften Schädigung des elektrochemischen Energiespeichers führen. Die Einrichtung beziehungsweise ihre Betriebsmodussteuerungseinrichtung, insbesondere der Tieftemperaturbetriebsmodus, ermöglicht, eine Schädigung des elektrochemischen Energiespeichers zu vermeiden, insbesondere bei einer tiefen Temperatur.

Insbesondere kann die Einrichtung zur, insbesondere mechanischen, Kopplung mit beziehungsweise Anbringung beziehungsweise Befestigung an, insbesondere in, dem Werkzeug ausgebildet sein. Insbesondere kann die Einrichtung zur, insbesondere lösbaren, Verbindung mit dem Werkzeug ausgebildet sein, insbesondere durch eine stoffschlüssige Verbindung wie eine Verklebung, eine kraftschlüssige Verbindung wie eine Rastbeziehungsweise Schnappverbindung und/oder ein formschlüssige Verbindung wie eine Verschraubung. Zusätzlich oder alternativ kann die Einrichtung an, insbesondere in, dem Werkzeug angeordnet sein, insbesondere ein Teil des Werkzeugs sein. Alternativ kann die Einrichtung getrennt von dem Werkzeug ausgebildet sein. Dies ermöglicht eine Nachrüstung der Einrichtung an dem Werkzeug. Insbesondere kann die Einrichtung als Gerät bezeichnet werden. Weiter zusätzlich oder alternativ kann die Einrichtung bei Anordnung an dem Werkzeug in direktem Kontakt mit dem Werkzeug sein, insbesondere einem Werkzeuggehäuse beziehungsweise einer Haube des Werkzeugs.

Das Werkzeug kann einen Elektroantriebsmotor oder einen Verbrennungsantriebsmotor aufweisen beziehungsweise mittels eines Elektromotors oder eines Verbrennungsmotors angetrieben sein.

Die Erfassungs- und/oder Auswerteeinrichtung kann dazu ausgebildet sein, die mindestens eine Größe und/oder die Betriebsdaten drahtlos zu erfassen, insbesondere ohne eine galvanische Verbindung mit dem Werkzeug beziehungsweise Komponenten des Werkzeugs aufzuweisen.

Insbesondere kann die Erfassungs- und/oder Auswerteeinrichtung einen Sensor aufweisen, wobei der Sensor dazu ausgebildet sein kann, die mindestens eine Größe zu erfassen beziehungsweise zu messen. Die Größe kann als Messgröße bezeichnet werden. Insbesondere kann der Sensor dazu ausgebildet sein, dass er dazu in der Lage sein kann, unabhängig davon, ob das Werkzeug mittels eines Elektromotors oder eines Verbrennungsmotors angetrieben sein kann, die Größe zu erfassen. Somit können Größen und damit auch Betriebsdaten für eine Vielzahl von Antriebstechnologien wie verbrennungsmotorgetrieben, kabelgebunden, Akkumulator-basiert mit derselben Einrichtung erfasst werden, insbesondere ohne dass eine leitungsgebundene Verbindung mit dem Werkzeug beziehungsweise mit Komponenten des Werkzeugs erforderlich sein braucht. Zusätzlich oder alternativ kann der Sensor ein induktiver Sensor sein, wie mindestens eine Spule. Mittels des induktiven Sensors kann es möglich sein, insbesondere im Betrieb des Werkzeugs, sich ändernde elektromagnetische und/oder magnetische Felder zu messen beziehungsweise zu detektieren, insbesondere verursacht durch Streufelder von Elektromotoren, Zündimpulse von Verbrennungsmotoren, Stromänderungen, sich bewegende Magnete in einem Schwungrad des Werkzeugs, eines Generators, etc. Insoweit sei auch auf die einschlägige Fachliteratur verwiesen.

Zusätzlich oder alternativ kann die Erfassungs- und/oder Auswerteeinrichtung einen Mikrocontroller aufweisen oder sein.

Weiter zusätzlich oder alternativ können die Betriebsdaten eine Betriebszeitdauer beziehungsweise Betriebsstunden des Werkzeugs sein, insbesondere während welcher der Elektromotor, soweit vorhanden, oder der Verbrennungsmotor, soweit vorhanden, aktiv sein kann. Es versteht sich, dass es sich bei den Betriebsdaten neben der Betriebszeitdauer auch um weitere werkzeugbetriebsrelevante Daten handeln kann wie um Antriebstemperaturen, Antriebsleistungen, Lastdaten, werkzeugbenutzerbezogene Daten, Ladezustände und/oder Spannungszustände eines Energiespeichers, Einsatzorte, usw. Insoweit sei auch auf die einschlägige Fachliteratur verwiesen.

Der Betriebsdatenspeicher kann mit der Erfassungs- und/oder Auswerteeinrichtung elektrisch verbunden sein.

Die Kommunikationsschnittstelle kann mit der Erfassungs- und/oder Auswerteeinrichtung und/oder dem Betriebsdatenspeicher elektrisch verbunden sein. Zusätzlich oder alternativ kann die Kommunikationsschnittstelle eine WLAN-Schnittstelle und/oder eine Bluetooth-Schnittstelle aufweisen oder sein. Weiter zusätzlich oder alternativ kann die Kommunikationsschnittstelle dazu ausgebildet sein, zu übertragen, unabhängig davon, ob sich ein Endgerät in Reichweite befindet oder nicht. Insoweit sei auch auf die einschlägige Fachliteratur verwiesen.

Das Endgerät kann beispielsweise basierend auf den empfangenen Betriebsdaten Auswertungen der Betriebsdaten vornehmen und diese einem Benutzer optisch aufbereitet darstellen.

Der elektrochemische Energiespeicher, insbesondere die Batterie, soweit vorhanden, kann die alleinige beziehungsweise einzige Energiequelle der Einrichtung sein, insbesondere wenn das Werkzeug nicht aktiv sein kann oder ist. In anderen Worten: die Einrichtung kann ohne äußere Energiequelle beziehungsweise Energieversorgung sein, insbesondere wenn das Werkzeug nicht aktiv sein kann oder ist.

Die Temperatur kann eine Temperatur des elektrochemischen Energiespeichers, insbesondere der Batterie, und/oder einer Umgebung des elektrochemischen Energiespeichers sein.

Der Normaltemperaturbetriebsmodus kann als Normaltemperaturbetriebsart bezeichnet werden. Zusätzlich oder alternativ kann der Tieftemperaturbetriebsmodus als Tieftemperaturbetriebsart bezeichnet werden.

Die entnommene Leistung kann eine Spitzenleistung und/oder eine mittlere Leistung sein.

Die Betriebsmodussteuerungseinrichtung kann mit der Erfassungs- und/oder Auswerteeinrichtung, dem Betriebsdatenspeicher und/oder der Kommunikationsschnittstelle elektrisch verbunden sein. Des Weiteren kann die Betriebsmodussteuerungseinrichtung mit dem elektrochemischen Energiespeicher, insbesondere der Batterie, soweit vorhanden, elektrisch verbunden sein. Insbesondere kann die Betriebsmodussteuerungseinrichtung einerseits mit der Erfassungs- und/oder Auswerteeinrichtung, dem Betriebsdatenspeicher und/oder der Kommunikationsschnittstelle und andererseits mit dem elektrochemischen Energiespeicher, soweit vorhanden, elektrisch verbunden sein beziehungsweise zwischengeschaltet sein. In anderen Worten: die Erfassungs- und/oder Auswerteeinrichtung, der Betriebsdatenspeicher und/oder die Kommunikationsschnittstelle können/kann, insbesondere jeweils, mittels der Betriebsmodussteuerungseinrichtung mit dem elektrochemischen Energiespeicher, soweit vorhanden, elektrisch verbunden sein. Anders formuliert: die Erfassungs- und/oder Auswerteeinrichtung, der Betriebsdatenspeicher und/oder die Kommunikationsschnittstelle brauchen, insbesondere jeweils, nicht unmittelbar mit dem elektrochemischen Energiespeicher, soweit vorhanden, elektrisch verbunden sein. Zusätzlich oder alternativ kann die Betriebsmodussteuerungseinrichtung einen Mikrocontroller und/oder einen Speicher aufweisen oder sein.

Die Einrichtung beziehungsweise ihre Erfassungs- und/oder Auswerteeinrichtung, ihr Betriebsdatenspeicher, ihre Kommunikationsschnittstelle und/oder ihre Betriebsmodussteuerungseinrichtung können/kann für eine elektrische Spannung von minimal 1 Volt (V) und/oder von maximal 12 V ausgebildet sein, insbesondere von 3 V. Zusätzlich oder alternativ kann die Einrichtung als elektrische Einrichtung bezeichnet werden.

In einer Weiterbildung der Erfindung weist die Einrichtung den elektrochemischen Energiespeicher, insbesondere die Batterie, auf. Insbesondere kann der elektrochemische Energiespeicher dazu ausgebildet sein, die Erfassungs- und/oder Auswerteeinrichtung, den Betriebsdatenspeicher, die Kommunikationsschnittstelle und/oder die Betriebsmodussteuerungseinrichtung im, insbesondere jeweiligen, Betrieb mit elektrischer Leistung zu versorgen. Zusätzlich oder alternativ kann eine Spannung, insbesondere ein Wert beziehungsweise ein Betrag der Spannung, des elektrochemischen Energiespeichers, insbesondere der Batterie, minimal 1 V und/oder maximal 12 V sein, insbesondere 3 V. Weiter zusätzlich oder alternativ kann der elektrochemische Energiespeicher, insbesondere die Batterie, wiederaufladbar oder nicht wiederaufladbar ausgebildet sein. Die wiederaufladbare Batterie kann als Akkumulator bezeichnet werden. Weiter zusätzlich oder alternativ kann die Batterie eine Knopfzelle, insbesondere eine CR 2032-Knopfzelle oder CR 2450-Knopfzelle, und/oder eine Lithium-Ionen-Batterie sein.

In einer Weiterbildung der Erfindung ist der Temperaturgrenzwert maximal plus (+) 10 Grad Celsius (°C), insbesondere maximal 0 °C, und/oder minimal minus (-) 20 °C, insbesondere minimal - 10 °C, insbesondere - 5 °C.

In einer Weiterbildung der Erfindung weist die Einrichtung einen, insbesondere elektrischen, Temperatursensor auf. Der Temperatursensor ist zur, insbesondere automatischen, Erfassung beziehungsweise Messung der Temperatur, insbesondere eines Werts beziehungsweise eines Betrags der Temperatur, und/oder einer von der Temperatur abhängigen Größe, insbesondere eines Werts beziehungsweise eines Betrags der Größe, ausgebildet. Die Betriebsmodussteuerungseinrichtung ist dazu ausgebildet, die Erfassungs- und/oder Auswerteeinrichtung, den Betriebsdatenspeicher und/oder die Kommunikationsschnittstelle bei Überschreitung des Temperaturgrenzwerts durch die erfasste beziehungsweise gemessene Temperatur, insbesondere ihren Wert, oder eines Größengrenzwerts durch die erfasste beziehungsweise gemessene Größe, insbesondere ihren Wert, in dem Normaltemperaturbetriebsmodus und bei Erreichung oder Unterschreitung des Temperaturgrenzwerts durch die erfasste beziehungsweise gemessene Temperatur, insbesondere ihren Wert, oder des Größengrenzwerts durch die erfasste beziehungsweise gemessene Größe, insbesondere ihren Wert, in dem Tieftemperaturbetriebsmodus zu betreiben, insbesondere automatisch. Insbesondere kann der Temperatursensor mit dem elektrochemischen Energiespeicher, insbesondere der Batterie, soweit vorhanden, thermisch verbunden sein. Insbesondere kann der Temperatursensor in einem Abstand von maximal 5 Zentimetern (cm), insbesondere von maximal 2 cm, insbesondere von maximal 1 cm, zu dem elektrochemischen Energiespeicher, soweit vorhanden, oder in direktem Kontakt beziehungsweise Berührung mit dem elektrochemischen Energiespeicher, soweit vorhanden, angeordnet sein. Zusätzlich oder alternativ kann die Betriebsmodussteuerungseinrichtung mit dem Temperatursensor elektrisch verbunden sein.

In einer Weiterbildung der Erfindung weist die Einrichtung eine, insbesondere elektrische, Widerstanderfassungseinrichtung, insbesondere einen Widerstandsensor, auf. Die Widerstanderfassungseinrichtung ist zur, insbesondere automatischen, Erfassung beziehungsweise Messung eines, insbesondere des, Widerstands, insbesondere eines Werts beziehungsweise eines Betrags des Widerstands, insbesondere Innenwiderstands, des elektrochemischen Energiespeichers, insbesondere der Batterie, und/oder einer von dem Widerstand abhängigen Größe, insbesondere eines Werts beziehungsweise eines Betrags der Größe, ausgebildet. Die Betriebsmodussteuerungseinrichtung ist dazu ausgebildet, die Erfassungs- und/oder Auswerteeinrichtung, den Betriebsdatenspeicher und/oder die Kommunikationsschnittstelle bei Unterschreitung eines Widerstandgrenzwerts durch den erfassten beziehungsweise gemessenen Widerstand, insbesondere seinen Wert, oder eines Größengrenzwerts durch die erfasste beziehungsweise gemessene Größe, insbesondere ihren Wert, in dem Normaltemperaturbetriebsmodus und bei Erreichung oder Überschreitung des Widerstandgrenzwerts durch den erfassten beziehungsweise gemessenen Widerstand, insbesondere seinen Wert, oder des Größengrenzwerts durch die erfasste beziehungsweise gemessene Größe, insbesondere ihren Wert, in dem Tieftemperaturbetriebsmodus zu betreiben, insbesondere automatisch. Im Detail kann der Widerstand, insbesondere der Innenwiderstand, des elektrochemischen Energiespeichers, insbesondere der Batterie, von der Temperatur abhängig beziehungsweise mit der Temperatur korreliert beziehungsweise verknüpft beziehungsweise eine Funktion der Temperatur sein. Insbesondere kann die Widerstanderfassungseinrichtung mit dem elektrochemischen Energiespeicher, soweit vorhanden, elektrisch verbunden sein. Zusätzlich oder alternativ kann die Betriebsmodussteuerungseinrichtung mit der Widerstanderfassungseinrichtung elektrisch verbunden sein.

In einer Ausgestaltung der Erfindung ist der Widerstandsgrenzwert minimal 100 Ohm (Ω), insbesondere minimal 500 Ω, und/oder maximal 20 Kiloohm (kΩ), insbesondere maximal 2 kΩ, insbesondere 1 kΩ.

In einer Weiterbildung der Erfindung ist die Betriebsmodussteuerungseinrichtung dazu ausgebildet ist, die Erfassungs- und/oder Auswerteeinrichtung, den Betriebsdatenspeicher und/oder die Kommunikationsschnittstelle in dem Normaltemperaturbetriebsmodus periodisch in, insbesondere jeweiligen, Intervallen während einer, insbesondere jeweiligen, ersten Aktivzeitdauer zu betreiben und während einer, insbesondere jeweiligen, ersten Inaktivzeitdauer, insbesondere zwischen den Intervallen, nicht zu betreiben und in dem Tieftemperaturmodus periodisch in, insbesondere jeweiligen, Intervallen während einer gegenüber der ersten zeitlich kürzeren zweiten Aktivzeitdauer zu betreiben und/oder während einer, insbesondere jeweiligen, gegenüber der ersten zeitlich längeren zweiten Inaktivzeitdauer, insbesondere zwischen den Intervallen, nicht zu betreiben oder leistungslos beziehungsweise funktionslos zu setzen beziehungsweise nicht zu betreiben, insbesondere automatisch. Insbesondere können/kann die Erfassungs- und/oder Auswerteeinrichtung, der Betriebsdatenspeicher und/oder die Kommunikationsschnittstelle, insbesondere jeweils, während der Aktivzeitdauer mit elektrischer Leistung versorgt beziehungsweise aktiviert werden und während der Inaktivzeitdauer nicht mit elektrischer Leistung versorgt beziehungsweise deaktiviert werden. Zusätzlich oder alternativ können die erste Aktivzeitdauer und die zweite Aktivzeitdauer zeitlich gleich lang sein und die erste Inaktivzeitdauer und die zweite Inaktivzeitdauer können zeitlich verschieden lang sein. Weiter zusätzlich oder alternativ kann die Einrichtung dazu ausgebildet sein, zeitlich längere Arbeitsaufgaben auf mehrere Intervalle aufzuteilen.

In einer Ausgestaltung der Erfindung ist die erste Aktivzeitdauer minimal 1 Millisekunden (ms) und/oder maximal 3 Sekunden (s), insbesondere 80 ms. Zusätzlich oder alternativ ist die erste Inaktivzeitdauer minimal 100 ms und/oder maximal 10 s, insbesondere 920 ms. Weiter zusätzlich oder alternativ ist die zweite Aktivzeitdauer minimal 1 ms und/oder maximal 3 s, insbesondere 40 ms. Weiter zusätzlich oder alternativ ist die zweite Inaktivzeitdauer minimal 500 ms und/oder maximal 10 s, insbesondere 1960 ms.

In einer Ausgestaltung der Erfindung ist die Betriebsmodussteuerungseinrichtung dazu ausgebildet, bei Nicht-Erfassung einer Größe oder Betriebsdaten mittels der Erfassungs- und/oder Auswerteeinrichtung die erste Inaktivzeitdauer auf einen maximalen Wert und/oder die zweite Inaktivzeitdauer auf einen maximalen Wert zu setzen, insbesondere automatisch. Dies ermöglicht einen relativ niedrigen Energieverbrauch, insbesondere wenn das Werkzeug nicht aktiv sein kann oder ist, und somit eine relativ lange Laufzeit des elektrochemischen Energiespeichers, insbesondere der Batterie, soweit vorhanden. Zusätzlich kann die Betriebsmodussteuerungseinrichtung dazu ausgebildet sein, bei Erfassung der Größe oder von Betriebsdaten mittels der Erfassungs- und/oder Auswerteeinrichtung die erste Inaktivzeitdauer auf einen minimalen Wert und/oder die zweite Inaktivzeitdauer auf einen minimalen Wert zu setzen. Weiter zusätzlich oder alternativ kann die Betriebsmodussteuerungseinrichtung dazu ausgebildet sein, bei zeitlich längerer Nicht-Erfassung und/oder bei zeitlich längerer Erfassung, insbesondere bei Erreichung oder Überschreitung eines Zeitgrenzwerts durch eine Zeitdauer seit einem Beginn der Nicht-Erfassung oder der Erfassung, beziehungsweise keiner Änderung die erste Inaktivzeitdauer auf einen maximalen Wert und/oder die zweite Inaktivzeitdauer auf einen maximalen Wert zu setzen, insbesondere automatisch.

In einer Weiterbildung der Erfindung weist die Einrichtung einen, insbesondere elektrischen, Pufferkondensator auf. Der Pufferkondensator ist dazu ausgebildet, dem elektrochemischen Energiespeicher, insbesondere der Batterie, elektrische Leistung zu entnehmen, insbesondere automatisch. Die Erfassungs- und/oder Auswerteeinrichtung, der Betriebsdatenspeicher und/oder die Kommunikationsschnittstelle sind/ist dazu ausgebildet, im Betrieb dem Pufferkondensator elektrische Leistung zu entnehmen, insbesondere automatisch. Dies ermöglicht einen Bedarf der Erfassungs- und/oder Auswerteeinrichtung, des Betriebsdatenspeichers und/oder der Kommunikationsschnittstelle an elektrischer Leistung, die zumindest kurzzeitig größer als die entnehmbare Leistung des elektrochemischen Energiespeichers, insbesondere der Batterie, sein kann, zu decken. Insbesondere kann der Pufferkondensator dazu ausgebildet sein, während der Inaktivzeitdauer, soweit vorgesehen, von dem elektrochemischen Energiespeicher, insbesondere teilweise, aufgeladen zu werden und während der Aktivzeitdauer, soweit vorgesehen, von der Erfassungs- und/oder Auswerteeinrichtung, dem Betriebsdatenspeicher und/oder der Kommunikationsschnittstelle, insbesondere teilweise, entladen zu werden. Insbesondere kann der Pufferkondensator dazu ausgebildet sein, den Bedarf an elektrischer Leistung während der Aktivzeitdauer vollständig zu decken. Insbesondere kann die Betriebsmodussteuerungseinrichtung dazu ausgebildet sein, die Inaktivzeitdauer derart zeitlich anzupassen beziehungsweise abzustimmen, insbesondere an die entnehmbare Leistung des elektrochemischen Energiespeichers, dass der Pufferkondensator ausreichend aufgeladen wird. Zusätzlich oder alternativ kann ein Spannungshub beziehungsweise ein Spannungsrippel, insbesondere ein Wert beziehungsweise ein Betrag des Spannungshubs, durch periodisches Aufladen und Entladen ein Teil der Spannung, insbesondere eines Werts beziehungsweise eines Betrags der Spannung, des elektrochemischen Energiespeichers, insbesondere der Batterie, sein. Weiter zusätzlich oder alternativ kann der Pufferkondensator ein MLCC-Kondensator sein und/oder ein X5R-Dielektrikum aufweisen. Weiter zusätzlich oder alternativ kann der Pufferkondensator einerseits mit der Betriebsmodussteuerungseinrichtung und andererseits mit dem elektrochemischen Energiespeicher, soweit vorhanden, elektrisch verbunden sein beziehungsweise zwischengeschaltet sein. In anderen Worten: die Betriebsmodussteuerungseinrichtung kann mittels des Pufferkondensators mit dem elektrochemischen Energiespeicher, soweit vorhanden, elektrisch verbunden sein. Anders formuliert: die Betriebsmodussteuerungseinrichtung braucht nicht unmittelbar mit dem elektrochemischen Energiespeicher, soweit vorhanden, elektrisch verbunden sein.

In einer Ausgestaltung der Erfindung weist der Pufferkondensator eine elektrische Kapazität von minimal 50 Mikrofarad (µF), insbesondere von minimal 100 µF, und/oder von maximal 5000 µF, insbesondere von maximal 1000 µF auf, insbesondere von 470 µF. Zusätzlich oder alternativ ist der Pufferkondensator für eine elektrische Spannung von minimal 1 V und von maximal 12 V ausgebildet, insbesondere von 3 V.

In einer Weiterbildung der Erfindung weist der Betriebsdatenspeicher einen EEPROM-Betriebsdatenspeicher auf. Der EEPROM-Betriebsdatenspeicher ist dazu ausgebildet, einzelne Bits, insbesondere nicht mehr benötigter Betriebsdaten, zu löschen, insbesondere automatisch. Dies ermöglicht, insbesondere im Gegensatz zu einem FLASH-Betriebsdatenspeicher mit blockweisem Löschvorgang, Zeit und somit Energie zu sparen. Insoweit sei auch auf die einschlägige Fachliteratur verwiesen. Zusätzlich oder alternativ kann die Einrichtung beziehungsweise ihr Betriebsdatenspeicher, insbesondere sein EEPROM-Betriebsdatenspeicher, dazu ausgebildet sein, einen größeren Löschvorgang auf mehrere Intervalle, soweit vorgesehen, aufzuteilen.

In einer Weiterbildung der Erfindung weist die Einrichtung eine, insbesondere elektrische, Ausgabeeinrichtung auf, insbesondere eine Anzeige. Die Ausgabeeinrichtung ist dazu ausgebildet, einen Ein-Zustand der Einrichtung auszugeben, insbesondere anzuzeigen, insbesondere automatisch. Die Ausgabeeinrichtung ist dazu ausgebildet, im Betrieb dem elektrochemischen Energiespeicher, insbesondere der Batterie, elektrische Leistung zu entnehmen, insbesondere automatisch. Die Betriebsmodussteuerungseinrichtung ist dazu ausgebildet, die Ausgabeeinrichtung, insbesondere bei einer Temperatur, insbesondere einem Wert beziehungsweise einem Betrag der Temperatur, oberhalb von einem, insbesondere dem, Temperaturgrenzwert in einem, insbesondere dem, Normaltemperaturbetriebsmodus und bei einer Temperatur, insbesondere einem Wert beziehungsweise einem Betrag der Temperatur, gleich oder unterhalb des Temperaturgrenzwerts in einem, insbesondere dem, von dem Normaltemperaturbetriebsmodus verschiedenen Tieftemperaturbetriebsmodus, derart zu betreiben, insbesondere automatisch, dass im Tieftemperaturbetriebsmodus dem elektrochemischen Energiespeicher, insbesondere der Batterie, von der beziehungsweise für die Ausgabeeinrichtung weniger, insbesondere keine, elektrische Leistung als im Normaltemperaturbetriebsmodus entnommen wird. Die Einrichtung beziehungsweise ihre Ausgabeeinrichtung ermöglicht den Ein-Zustand der Einrichtung dem Benutzer auszugeben. Insbesondere kann die Betriebsmodussteuerungseinrichtung mit der Ausgabeeinrichtung elektrisch verbunden sein. Insbesondere kann die Betriebsmodussteuerungseinrichtung einerseits mit der Ausgabeeinrichtung und andererseits mit dem elektrochemischen Energiespeicher, soweit vorhanden, elektrisch verbunden sein beziehungsweise zwischengeschaltet sein. In anderen Worten: die Ausgabeeinrichtung kann mittels der Betriebsmodussteuerungseinrichtung mit dem elektrochemischen Energiespeicher, soweit vorhanden, elektrisch verbunden sein. Anders formuliert: die Ausgabeeinrichtung braucht nicht unmittelbar mit dem elektrochemischen Energiespeicher, soweit vorhanden, elektrisch verbunden sein.

Die oben beschriebene Einrichtung mit allen ihren oder einem Teil ihrer Eigenschaften kann dazu vorgesehen sein, mit dem motorangetriebenen Werkzeug, insbesondere das mittels eines Elektromotors und/oder mittels eines Verbrennungsmotors angetrieben sein kann, zur Erfassung von Betriebsdaten des Werkzeugs verwendet werden zu können. In anderen Worten: Verwendung der Einrichtung zur Erfassung von Betriebsdaten des motorangetriebenen Werkzeugs, insbesondere das mittels eines Elektromotors und/oder mittels eines Verbrennungsmotors angetrieben sein kann.

Das erfindungsgemäße System weist eine oben beschriebene Einrichtung und ein motorangetriebenes Werkzeug auf. Insbesondere kann das Werkzeug teilweise oder ganz wie oben beschrieben ausgebildet sein.

In einer Weiterbildung der Erfindung ist das motorangetriebene Werkzeug ein handgeführtes, insbesondere handgetragenes oder bodengeführtes, Werkzeug. Insbesondere handgeführtes, insbesondere handgetragenes, Werkzeug kann bedeuten, dass das Werkzeug eine Masse von maximal 50 Kilogramm (kg), insbesondere von maximal 20 kg, insbesondere von maximal 10 kg, aufweisen kann. Zusätzlich oder alternativ kann das Werkzeug ein Garten- und/oder Forstbearbeitungswerkzeug oder ein Bodenbearbeitungswerkzeug sein.

Insbesondere kann das Werkzeug eine Säge, oder ein Hoch-Entaster, oder eine Heckenschere, oder ein Heckenschneider, oder ein Laubbläser, oder ein Laubsauger, oder eine Kehrwalze, oder eine Kehrbürste, oder ein Rasenmäher, oder ein Freischneider, oder ein Vertikutierer, oder ein Trennschleifer, oder eine Motorhacke, oder ein Hochdruckreiniger, oder ein Spritzbeziehungsweise Sprühgerät, oder ein Bohrgerät sein.

Zusätzlich oder alternativ zu dem motorangetriebenen Werkzeug kann das System ein Endgerät aufweisen. Insbesondere kann das Endgerät teilweise oder ganz wie oben beschrieben ausgebildet sein. Zusätzlich oder alternativ kann das Endgerät eine beliebige datenverarbeitende Einrichtung sein, die eine geeignete drahtlose Schnittstelle aufweisen kann, die zur drahtlosen Kommunikation mit der Kommunikationsschnittstelle der Einrichtung zur Erfassung von Betriebsdaten ausgebildet sein kann. Weiter zusätzlich oder alternativ kann das Endgerät ein Gateway bilden beziehungsweise sein, das die empfangenen Betriebsdaten an einen Server weiterleiten kann wie an einen sogenannten Cloud-Speicher, der die Betriebsdaten speichern kann. Die im Cloud-Speicher gespeicherten Betriebsdaten können dann mittels eines geeigneten Tools wie eines Web-Browsers betrachtet und ausgewertet werden. Weiter zusätzlich oder alternativ kann das Endgerät ein mobiles Endgerät wie ein Laptop, ein Tablet oder ein Smartphone sein. Insbesondere mobil kann als portabel oder handgeführt, insbesondere handgetragen, bezeichnet werden.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Dabei zeigen:
- Fig. 1: ein schematisches Blockschaltbild eines erfindungsgemäßen Systems mit einer erfindungsgemäßen Einrichtung zur Erfassung von Betriebsdaten eines motorangetriebenen Werkzeugs, dem motorangetriebenen Werkzeug und einem Endgerät,
- Fig. 2: einen Graph eine elektrischen Leistung der Einrichtung der Fig. 1 in einem Normaltemperaturbetriebsmodus über der Zeit,
- Fig. 3: einen Graph eine elektrischen Leistung der Einrichtung der Fig. 1 in einem Tieftemperaturbetriebsmodus über der Zeit,
- Fig. 4: eine schematische Explosionsansicht der Einrichtung der Fig. 1,
- Fig. 5: eine schematische Längsschnittansicht der Einrichtung der Fig. 1, und
- Fig. 6: eine schematische Perspektivansicht eines Ausschnitts des motorangetriebenen Werkzeugs der Fig. 1.

### DETAILLIERTE BESCHREIBUNG DER AUSFÜHRUNGSBEISPIELE

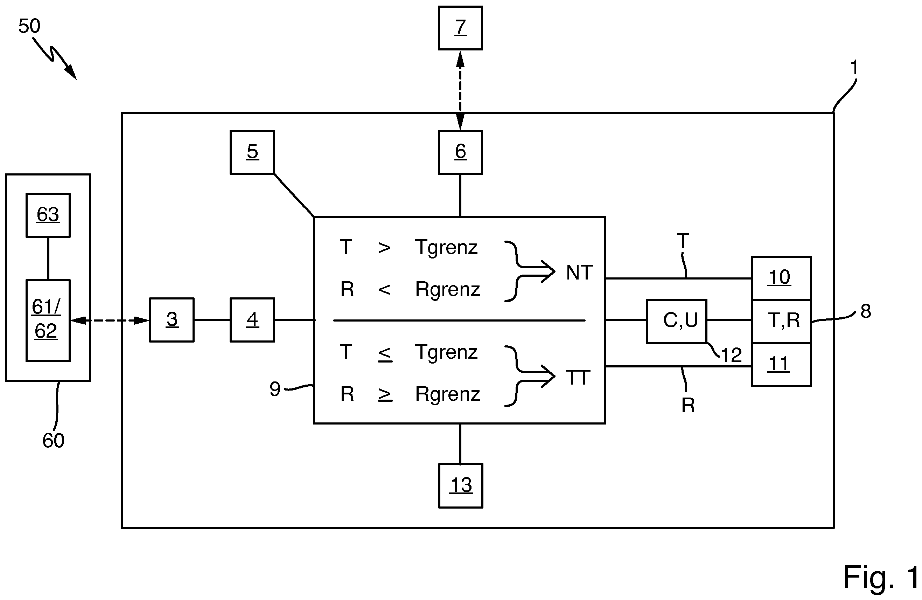

Fig. 1 und 4 bis 6 zeigen ein erfindungsgemäßes System 50. Das System 50 weist eine Einrichtung 1 und ein motorangetriebenes Werkzeug 60 auf.

Im Detail weist das Werkzeug 60 einen Elektroantriebsmotor 61 oder einen Verbrennungsantriebsmotor 62 auf, wie in Fig. 1 gezeigt.

Des Weiteren ist das motorangetriebene Werkzeug 60 ein handgeführtes Werkzeug. Im gezeigten Ausführungsbeispiel ist das handgeführte Werkzeug 60 ein handgetragenes Werkzeug. In alternativen Ausführungsbeispielen kann das handgeführte Werkzeug ein bodengeführtes Werkzeug sein.

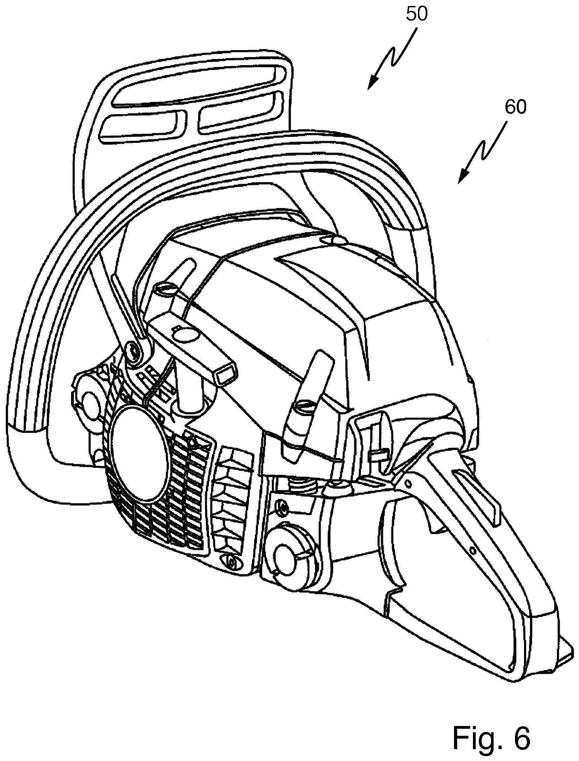

Im Detail ist das Werkzeug 60 eine Säge, wie in Fig. 6 gezeigt. Die Säge 60 weist eine Sägekette 63 auf, wobei insbesondere der Elektroantriebsmotor 61 oder der Verbrennungsantriebsmotor 62 zum Antrieb der Sägekette 63 ausgebildet ist. In alternativen Ausführungsbeispielen kann das Werkzeug ein Hoch-Entaster, oder eine Heckenschere, oder ein Heckenschneider, oder ein Laubbläser, oder ein Laubsauger, oder eine Kehrwalze, oder eine Kehrbürste, oder ein Rasenmäher, oder ein Freischneider, oder ein Vertikutierer, oder ein Trennschleifer, oder eine Motorhacke, oder ein Hochdruckreiniger, oder ein Spritzbeziehungsweise Sprühgerät, oder ein Bohrgerät sein.

Zusätzlich weist das System 12 ein Endgerät 7 auf.

Die erfindungsgemäße Einrichtung 1 ist zur Erfassung von Betriebsdaten des motorangetriebenen Werkzeugs 60 ausgebildet. Außerdem ist die Einrichtung 1 zur Anordnung an dem Werkzeug 60 ausgebildet beziehungsweise im gezeigten Ausführungsbeispiel an dem Werkzeug 60 angeordnet. Weiter weist die Einrichtung eine Erfassungs- und/oder Auswerteeinrichtung 3, 4 auf, wie in Fig. 1, 4 und 5 gezeigt. Die Erfassungs- und/oder Auswerteeinrichtung 3, 4 ist dazu ausgebildet, mindestens eine Größe zu erfassen, wobei die Größe von einem Betriebszustand des Werkzeugs 60 abhängig ist, und die erfasste Größe zur Ermittlung der Betriebsdaten auszuwerten. Zusätzlich oder alternativ ist die Erfassungs- und/oder Auswerteeinrichtung 3, 4 dazu ausgebildet, Betriebsdaten zu erfassen. Zudem weist die Einrichtung einen Betriebsdatenspeicher 5 und/oder eine Kommunikationsschnittstelle 6 auf. Der Betriebsdatenspeicher 5 ist dazu ausgebildet, die ermittelten und/oder erfassten Betriebsdaten zu speichern. Die Kommunikationsschnittstelle 6 ist dazu ausgebildet, die Betriebsdaten drahtlos zu dem Endgerät 7 zu übertragen. Die Erfassungs- und/oder Auswerteeinrichtung 3, 4, der Betriebsdatenspeicher 5 und/oder die Kommunikationsschnittstelle 6 sind/ist dazu ausgebildet, im Betrieb einem elektrochemischen Energiespeicher 8, insbesondere einer Batterie, elektrische Leistung P8 zu entnehmen. Des Weiteren weist die Einrichtung eine Betriebsmodussteuerungseinrichtung 9 in Form eines Mikrocontrollers und eines Speichers auf. Die Betriebsmodussteuerungseinrichtung 9 ist dazu ausgebildet, die Erfassungs- und/oder Auswerteeinrichtung 3, 4, den Betriebsdatenspeicher 5 und/oder die Kommunikationsschnittstelle 6 bei einer Temperatur T oberhalb von einem Temperaturgrenzwert Tgrenz in einem Normaltemperaturbetriebsmodus NT und bei einer Temperatur T gleich oder unterhalb des Temperaturgrenzwerts Tgrenz in einem von dem Normaltemperaturbetriebsmodus NT verschiedenen Tieftemperaturbetriebsmodus TT derart zu betreiben, dass im Tieftemperaturbetriebsmodus TT dem elektrochemischen Energiespeicher 8, insbesondere der Batterie, weniger elektrische Leistung P8 als im Normaltemperaturbetriebsmodus NT entnommen wird.

Im gezeigten Ausführungsbeispiel weist die Erfassungs- und/oder Auswerteeinrichtung 3, 4 einen Erfassungsteil 3 in Form eines Sensors und einen Auswerteteil 4 in Form eines Mikrocontrollers auf. In alternativen Ausführungsbeispielen kann die Erfassungs- und/oder Auswerteeinrichtung anders ausgebildet sein.

Außerdem weist im gezeigten Ausführungsbeispiel die Einrichtung 1 den Betriebsdatenspeicher 5 und die Kommunikationsschnittstelle 6 auf. In alternativen Ausführungsbeispielen kann die Einrichtung entweder den Betriebsdatenspeicher oder die Kommunikationsschnittstelle aufweisen.

Im Detail weist der Betriebsdatenspeicher 5 einen EEPROM-Betriebsdatenspeicher auf. Der EEPROM-Betriebsdatenspeicher 5 ist dazu ausgebildet, einzelne Bits zu löschen.

Weiter ist im gezeigten Ausführungsbeispiel die Betriebsmodussteuerungseinrichtung 9 dazu ausgebildet, die Erfassungs- und/oder Auswerteeinrichtung 3, 4, den Betriebsdatenspeicher 5 und die Kommunikationsschnittstelle 6 in dem Normaltemperaturbetriebsmodus NT und in dem Tieftemperaturbetriebsmodus TT zu betreiben. In alternativen Ausführungsbeispielen kann die Betriebsmodussteuerungseinrichtung dazu ausgebildet sein, entweder die Erfassungs- und/oder Auswerteeinrichtung oder den Betriebsdatenspeicher oder die Kommunikationsschnittstelle in dem Normaltemperaturbetriebsmodus und in dem Tieftemperaturbetriebsmodus zu betreiben.

Zusätzlich weist die Einrichtung 1 den elektrochemischen Energiespeicher 8 in Form der Batterie auf. Im gezeigten Ausführungsbeispiel ist die Batterie eine CR 2032-Knopfzelle, insbesondere mit einer Spannung von 3 V. In alternativen Ausführungsbeispielen kann die Batterie eine CR 2450-Knopfzelle sein oder anders ausgebildet sein.

Im gezeigten Ausführungsbeispiel ist der Temperaturgrenzwert Tgrenz - 5 °C. In alternativen Ausführungsbeispielen kann der Temperaturgrenzwert maximal + 10 °C und/oder minimal - 20 °C sein.

Zudem weist die Einrichtung 1 einen Temperatursensor 10 oder eine Widerstanderfassungseinrichtung 11 auf.

Im gezeigten Ausführungsbeispiel ist der Temperatursensor 10 zur Erfassung der Temperatur T, insbesondere des elektrochemischen Energiespeichers beziehungsweise der Batterie 8, ausgebildet. Die Betriebsmodussteuerungseinrichtung 9 ist dazu ausgebildet, die Erfassungs- und/oder Auswerteeinrichtung 3, 4, den Betriebsdatenspeicher 5 und/oder die Kommunikationsschnittstelle 6 bei Überschreitung des Temperaturgrenzwerts Tgrenz durch die erfasste Temperatur T in dem Normaltemperaturbetriebsmodus NT und bei Erreichung oder Unterschreitung des Temperaturgrenzwerts Tgrenz durch die erfasste Temperatur T in dem Tieftemperaturbetriebsmodus TT zu betreiben.

In alternativen Ausführungsbeispielen kann der Temperatursensor zusätzlich oder alternativ zur Erfassung einer von der Temperatur abhängigen Größe ausgebildet sein. Die Betriebsmodussteuerungseinrichtung kann dazu ausgebildet sein, die Erfassungs- und/oder Auswerteeinrichtung, den Betriebsdatenspeicher und/oder die Kommunikationsschnittstelle bei Überschreitung eines Größengrenzwerts durch die erfasste Größe in dem Normaltemperaturbetriebsmodus und bei Erreichung oder Unterschreitung des Größengrenzwerts durch die erfasste Größe in dem Tieftemperaturbetriebsmodus zu betreiben.

Im Detail ist der Temperatursensor 10 mit dem elektrochemischen Energiespeicher beziehungsweise der Batterie 8 thermisch verbunden. Im gezeigten Ausführungsbeispiel ist der Temperatursensor 10 in direktem Kontakt mit dem elektrochemischen Energiespeicher beziehungsweise der Batterie 8 angeordnet. In alternativen Ausführungsbeispielen kann der Temperatursensor in einem Abstand von maximal 5 cm zu dem elektrochemischen Energiespeicher beziehungsweise der Batterie angeordnet sein. Des Weiteren ist die Betriebsmodussteuerungseinrichtung 9 mit dem Temperatursensor 10 elektrisch verbunden.

Im gezeigten Ausführungsbeispiel ist die Widerstanderfassungseinrichtung 11 zur Erfassung eines Widerstands R des elektrochemischen Energiespeichers beziehungsweise der Batterie 8 ausgebildet. Die Betriebsmodussteuerungseinrichtung 9 ist dazu ausgebildet, die Erfassungs- und/oder Auswerteeinrichtung 3, 4, den Betriebsdatenspeicher 5 und/oder die Kommunikationsschnittstelle 6 bei Unterschreitung eines Widerstandgrenzwerts Rgrenz durch den erfassten Widerstand R in dem Normaltemperaturbetriebsmodus NT und bei Erreichung oder Überschreitung des Widerstandgrenzwerts Rgrenz durch den erfassten Widerstand R in dem Tieftemperaturbetriebsmodus TT zu betreiben.

In alternativen Ausführungsbeispielen kann die Widerstanderfassungseinrichtung zusätzlich oder alternativ zur Erfassung einer von dem Widerstand abhängigen Größe ausgebildet sein. Die Betriebsmodussteuerungseinrichtung kann dazu ausgebildet sein, die Erfassungs- und/oder Auswerteeinrichtung, den Betriebsdatenspeicher und/oder die Kommunikationsschnittstelle bei Unterschreitung eines Größengrenzwerts durch die erfasste Größe in dem Normaltemperaturbetriebsmodus und bei Erreichung oder Überschreitung des Größengrenzwerts durch die erfasste Größe in dem Tieftemperaturbetriebsmodus zu betreiben.

Im Detail ist die Widerstanderfassungseinrichtung 11 mit dem elektrochemischen Energiespeicher beziehungsweise der Batterie 8 elektrisch verbunden. Außerdem ist die Betriebsmodussteuerungseinrichtung 9 mit der Widerstanderfassungseinrichtung 11 elektrisch verbunden.

Im gezeigten Ausführungsbeispiel ist der Widerstandsgrenzwert Rgrenz 1 kΩ. In alternativen Ausführungsbeispielen kann der Widerstandsgrenzwert minimal 100 Ω und/oder maximal 20 kΩ sein.

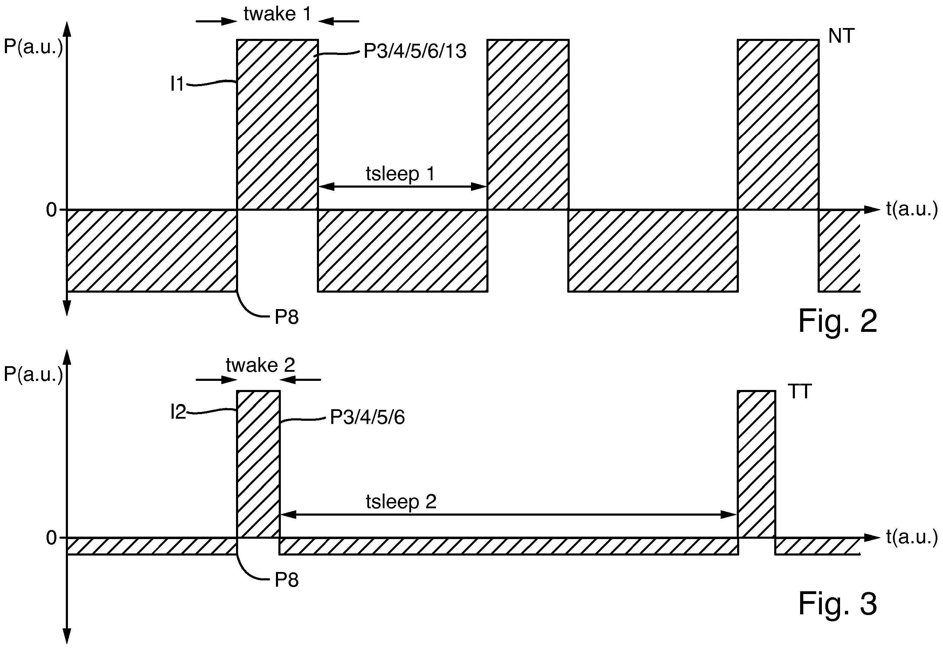

Weiter ist die Betriebsmodussteuerungseinrichtung 9 dazu ausgebildet, die Erfassungs- und/oder Auswerteeinrichtung 3, 4, den Betriebsdatenspeicher 5 und/oder die Kommunikationsschnittstelle 6 in dem Normaltemperaturbetriebsmodus NT periodisch in Intervallen I1 während einer ersten Aktivzeitdauer twake1 zu betreiben und während einer ersten Inaktivzeitdauer tsleepl nicht zu betreiben, wie in Fig. 2 gezeigt, und in dem Tieftemperaturmodus periodisch in Intervallen I2 während einer gegenüber der ersten zeitlich kürzeren zweiten Aktivzeitdauer twake2 zu betreiben und/oder während einer gegenüber der ersten zeitlich längeren zweiten Inaktivzeitdauer tsleep2 nicht zu betreiben oder leistungslos zu setzen, wie in Fig. 3 gezeigt.

Im gezeigten Ausführungsbeispiel ist die erste Aktivzeitdauer twake1 80 ms. In alternativen Ausführungsbeispielen kann die erste Aktivzeitdauer minimal 1 ms und/oder maximal 3 s sein.

Des Weiteren ist im gezeigten Ausführungsbeispiel die erste Inaktivzeitdauer tsleepl 920 ms. In alternativen Ausführungsbeispielen kann die erste Inaktivzeitdauer minimal 100 ms und/oder maximal 10 s sein.

Außerdem ist im gezeigten Ausführungsbeispiel die zweite Aktivzeitdauer twake2 40 ms. In alternativen Ausführungsbeispielen kann die zweite Aktivzeitdauer minimal 1 ms und/oder maximal 3 s sein.

Weiter ist im gezeigten Ausführungsbeispiel die zweite Inaktivzeitdauer tsleep2 1960 ms. In alternativen Ausführungsbeispielen kann die zweite Inaktivzeitdauer minimal 500 ms und/oder maximal 10 s sein.

Insbesondere können in alternativen Ausführungsbeispielen die erste Aktivzeitdauer und die zweite Aktivzeitdauer zeitlich gleich lang sein und die erste Inaktivzeitdauer und die zweite Inaktivzeitdauer können zeitlich verschieden lang sein.

Zudem ist die Betriebsmodussteuerungseinrichtung 9 dazu ausgebildet, bei Nicht-Erfassung mittels der Erfassungs- und/oder Auswerteeinrichtung 3, 4 die erste Inaktivzeitdauer tsleepl auf einen maximalen Wert und/oder die zweite Inaktivzeitdauer tsleep2 auf einen maximalen Wert zu setzen.

Zusätzlich ist die Betriebsmodussteuerungseinrichtung 9 dazu ausgebildet, bei Erfassung mittels der Erfassungs- und/oder Auswerteeinrichtung 3, 4 die erste Inaktivzeitdauer tsleepl auf 920 ms und/oder die zweite Inaktivzeitdauer tsleep2 auf 1960 ms zu setzen.

Des Weiteren weist die Einrichtung 1 einen Pufferkondensator 12 auf. Der Pufferkondensator 12 ist dazu ausgebildet, dem elektrochemischen Energiespeicher beziehungsweise der Batterie 8 elektrische Leistung P8 zu entnehmen. Die Erfassungs- und/oder Auswerteeinrichtung 3, 4, der Betriebsdatenspeicher 5 und/oder die Kommunikationsschnittstelle 6 sind/ist dazu ausgebildet, im Betrieb dem Pufferkondensator 12 elektrische Leistung P3/4/5/6 zu entnehmen.

Im gezeigten Ausführungsbeispiel weist der Pufferkondensator 12 eine elektrische Kapazität C von 470 µF auf. In alternativen Ausführungsbeispielen kann der Pufferkondensator eine elektrische Kapazität von minimal 50 µF und/oder von maximal 5000 µF aufweisen.

Außerdem ist im gezeigten Ausführungsbeispiel der Pufferkondensator 12 für eine elektrische Spannung von 3 V ausgebildet. In alternativen Ausführungsbeispielen kann der Pufferkondensator für eine elektrische Spannung von minimal 1 V und von maximal 12 V ausgebildet sein.

Weiter weist die Einrichtung 1 eine Ausgabeeinrichtung 13 auf, insbesondere eine Anzeige in Form einer Leuchtdiode. Die Ausgabeeinrichtung 13 ist dazu ausgebildet, einen Ein-Zustand der Einrichtung 1 auszugeben, insbesondere anzuzeigen. Die Ausgabeeinrichtung 13 ist dazu ausgebildet, im Betrieb dem elektrochemischen Energiespeicher beziehungsweise der Batterie 8 elektrische Leistung P8 zu entnehmen. Die Betriebsmodussteuerungseinrichtung 9 ist dazu ausgebildet, die Ausgabeeinrichtung 13 derart zu betreiben, dass im Tieftemperaturbetriebsmodus TT dem elektrochemischen Energiespeicher beziehungsweise der Batterie 8 von der Ausgabeeinrichtung 13 weniger elektrische Leistung P8 als im Normaltemperaturbetriebsmodus NT entnommen wird.

Im Detail ist der Pufferkondensator 12 einerseits mit dem elektrochemischen Energiespeicher beziehungsweise der Batterie 8 und andererseits mit der Betriebsmodussteuerungseinrichtung 9 elektrisch verbunden. Die Betriebsmodussteuerungseinrichtung 9 ist einerseits mit dem Pufferkondensator 12 und andererseits mit der Erfassungs- und/oder Auswerteeinrichtung 3, 4, dem Betriebsdatenspeicher 5, der Kommunikationsschnittstelle 6 und der Ausgabeeinrichtung 13 elektrisch verbunden.

Im gezeigten Ausführungsbeispiel sind/ist die Einrichtung 1 beziehungsweise ihre Erfassungs- und/oder Auswerteeinrichtung 3, 4, ihr Betriebsdatenspeicher 5, ihre Kommunikationsschnittstelle 6, ihre Betriebsmodussteuerungseinrichtung 9 und/oder ihre Ausgabeeinrichtung 13 für eine elektrische Spannung von 3 V ausgebildet.

Der Pufferkondensator 12 deckt einen Bedarf der Erfassungs- und/oder Auswerteeinrichtung 3, 4, des Betriebsdatenspeichers 5, der Kommunikationsschnittstelle 6 und/oder der Ausgabeeinrichtung 13 an elektrischer Leistung P3/4/5/6/13, die während der Aktivzeitdauer twake1, twake2 größer als die entnehmbare Leistung P8 des elektrochemischen Energiespeichers beziehungsweise der Batterie 8 ist, insbesondere vollständig, wie in Fig. 2 und 3 gezeigt.

Im Detail wird der Pufferkondensator 12 während der Inaktivzeitdauer tsleep1, tsleep2 von dem elektrochemischen Energiespeicher beziehungsweise der Batterie 8 aufgeladen und während der Aktivzeitdauer twake1, twake2 von der Erfassungs- und/oder Auswerteeinrichtung 3, 4, dem Betriebsdatenspeicher 5, der Kommunikationsschnittstelle 6 und/oder der Ausgabeeinrichtung 13 entladen, wie in Fig. 2 und 3 gezeigt. Ein Spannungshub durch periodisches Aufladen und Entladen des Pufferkondensators 12 ist ein Teil der Spannung des elektrochemischen Energiespeichers beziehungsweise der Batterie 8, insbesondere 200 mV bei 3 V beziehungsweise 2,9 V bis 3,1 V.

Im Normaltemperaturbetriebsmodus NT betreibt die Betriebsmodussteuerungseinrichtung 9 die Erfassungs- und/oder Auswerteeinrichtung 3, 4, den Betriebsdatenspeicher 5, die Kommunikationsschnittstelle 6 und/oder die Ausgabeeinrichtung 13 periodisch in den Intervallen I1 während der ersten Aktivzeitdauer twake1 und nicht während der ersten Inaktivzeitdauer tsleep1, wie in Fig. 2 gezeigt.

Mit sinkender Temperatur T sinkt die entnehmbare Leistung P8 des elektrochemischen Energiespeichers beziehungsweise der Batterie 8.

Im Tieftemperaturbetriebsmodus TT betreibt die Betriebsmodussteuerungseinrichtung 9 die Erfassungs- und/oder Auswerteeinrichtung 3, 4, den Betriebsdatenspeicher 5 und/oder die Kommunikationsschnittstelle 6 periodisch in den Intervallen I2 während der zweiten Aktivzeitdauer twake2 und nicht während der zweiten Inaktivzeitdauer tsleep2, wie in Fig. 3 gezeigt. Zudem setzt die Betriebsmodussteuerungseinrichtung 9 die Ausgabeeinrichtung 13 im Tieftemperaturbetriebsmodus TT funktionslos beziehungsweise betreibt diese nicht beziehungsweise lässt diese aus.

Die Einrichtung 1 beziehungsweise der Nicht-Betrieb beziehungsweise das Auslassen der Ausgabeeinrichtung 13 ermöglicht zwar nicht mehr, den Ein-Zustand der Einrichtung 1 dem Benutzer auszugeben. Jedoch überträgt die Kommunikationsschnittstelle 6 noch die Betriebsdaten drahtlos zu dem Endgerät 7 und ermöglicht somit, dem Benutzer den Ein-Zustand der Einrichtung 1 zu erfahren beziehungsweise mitzubekommen.

Im gezeigten Ausführungsbeispiel ist die Einrichtung 1 beziehungsweise ihr Pufferkondensator 12 für einen Betrieb der Einrichtung 1 bis inklusive - 30 °C ausgelegt. In alternativen Ausführungsbeispielen kann die Einrichtung beziehungsweise ihr Pufferkondensator für einen Betrieb der Einrichtung für einen anderen Temperaturwert ausgelegt sein.

Im Detail ist im gezeigten Ausführungsbeispiel der Temperaturgrenzwert Tgrenz für die Erfassungs- und/oder Auswerteeinrichtung 3, 4, den Betriebsdatenspeicher 5, die Kommunikationsschnittstelle 6 und die Ausgabeeinrichtung 13 derselbe. In alternativen Ausführungsbeispielen kann der Temperaturgrenzwert für die Erfassungs- und/oder Auswerteeinrichtung, den Betriebsdatenspeicher, die Kommunikationsschnittstelle und die Ausgabeeinrichtung, soweit vorhanden, verschieden beziehungsweise individuell sein.

Des Weiteren ist im gezeigten Ausführungsbeispiel der Widerstandsgrenzwert Rgrenz für die Erfassungs- und/oder Auswerteeinrichtung 3, 4, den Betriebsdatenspeicher 5, die Kommunikationsschnittstelle 6 und die Ausgabeeinrichtung 13 derselbe. In alternativen Ausführungsbeispielen kann der Widerstandsgrenzwert für die Erfassungs- und/oder Auswerteeinrichtung, den Betriebsdatenspeicher, die Kommunikationsschnittstelle und die Ausgabeeinrichtung, soweit vorhanden, verschieden beziehungsweise individuell sein.

Außerdem ist im gezeigten Ausführungsbeispiel die erste Aktivzeitdauer twake1, die erste Inaktivzeitdauer tsleep1, die zweite Aktivzeitdauer twake2 und die zweite Inaktivzeitdauer tsleep2, insbesondere jeweils, für die Erfassungs- und/oder Auswerteeinrichtung 3, 4, den Betriebsdatenspeicher 5, die Kommunikationsschnittstelle 6 und die Ausgabeeinrichtung 13 dieselbe. In alternativen Ausführungsbeispielen können/kann die erste Aktivzeitdauer, die erste Inaktivzeitdauer, die zweite Aktivzeitdauer und/oder die zweite Inaktivzeitdauer, insbesondere jeweils, für die Erfassungs- und/oder Auswerteeinrichtung, den Betriebsdatenspeicher, die Kommunikationsschnittstelle und die Ausgabeeinrichtung, soweit vorhanden, verschieden beziehungsweise individuell sein.

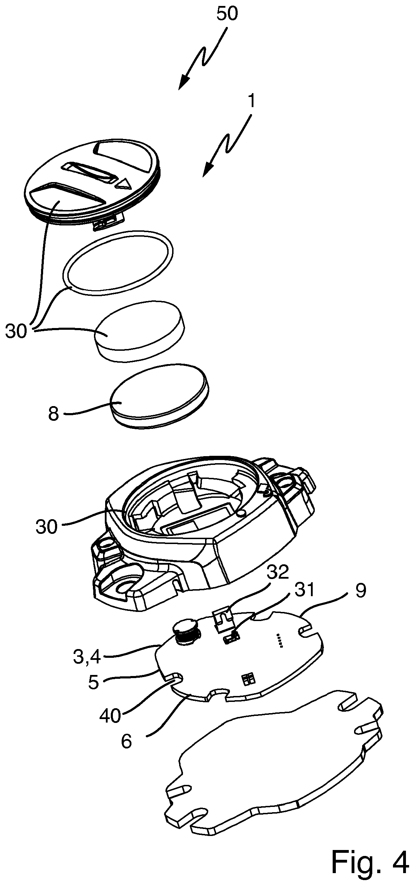

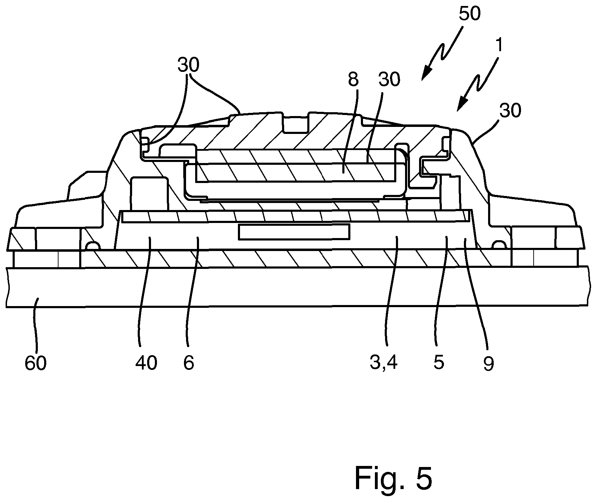

Weiter ist die Einrichtung 1 getrennt von dem motorangetriebenen Werkzeug 60 ausgebildet, wie in Fig. 4 und 5 gezeigt.

Zudem weist die Einrichtung 1 ein Gehäuse 30 auf. Das Gehäuse 30 ist zur Aufnahme des elektrochemischen Energiespeichers beziehungsweise der Batterie 8 ausgebildet.

Des Weiteren weist die Einrichtung 1 federnde elektrische Kontaktelemente 31, 32 auf, im gezeigten Ausführungsbeispiel zwei. Die federnden elektrischen Kontaktelemente 31, 32 sind dazu ausgebildet, korrespondierende elektrische Kontakte des aufgenommenen elektrochemischen Energiespeichers beziehungsweise der aufgenommenen Batterie 8 elektrisch zu kontaktieren.

Außerdem sind die Kontaktelemente 31, 32 aus dem Gehäuse 30 nach außen herausgeführt und dort elektrisch mit korrespondierenden Anschlüssen, insbesondere auf einer Platine 40 der Einrichtung 1, verbunden.

Im Detail ist die Platine 40 an einer Unterseite des Gehäuses 30 angeordnet. Insbesondere ist die Platine 40 mit dem Gehäuse 30 mechanisch verbunden.

Im gezeigten Ausführungsbeispiel weist die Platine 40 die Erfassungs- und/oder Auswerteeinrichtung 3, 4, den Betriebsdatenspeicher 5, die Kommunikationsschnittstelle 6 und die Betriebsmodussteuerungseinrichtung 9 auf.

Wie die gezeigten und oben erläuterten Ausführungsbeispiele deutlich machen, stellt die Erfindung eine Einrichtung zur Erfassung von Betriebsdaten eines motorangetriebenen Werkzeugs, die zuverlässig ist, insbesondere bei einer tiefen Temperatur, und ein System mit einer solchen Einrichtung und einem motorangetriebenen Werkzeug bereit.

## Patentansprüche

1. Einrichtung (1) zur Erfassung von Betriebsdaten eines motorangetriebenen Werkzeugs (60), wobei die Einrichtung (1) zur Anordnung an dem Werkzeug (60) ausgebildet ist, wobei die Einrichtung (1) aufweist:
- eine Erfassungs- und/oder Auswerteeinrichtung (3, 4), wobei die Erfassungs- und/oder Auswerteeinrichtung (3, 4) dazu ausgebildet ist, mindestens eine Größe zu erfassen, wobei die Größe von einem Betriebszustand des Werkzeugs (60) abhängig ist, und die erfasste Größe zur Ermittlung der Betriebsdaten auszuwerten, und/oder Betriebsdaten zu erfassen,
- einen Betriebsdatenspeicher (5), wobei der Betriebsdatenspeicher (5) dazu ausgebildet ist, die ermittelten und/oder erfassten Betriebsdaten zu speichern, und/oder eine Kommunikationsschnittstelle (6), wobei die Kommunikationsschnittstelle (6) dazu ausgebildet ist, die Betriebsdaten drahtlos zu einem Endgerät (7) zu übertragen, und
- wobei die Erfassungs- und/oder Auswerteeinrichtung (3, 4), der Betriebsdatenspeicher (5) und/oder die Kommunikationsschnittstelle (6) dazu ausgebildet sind/ist, im Betrieb einem elektrochemischen Energiespeicher (8) elektrische Leistung (P8) zu entnehmen, **dadurch gekennzeichnet, dass**
- die Einrichtung (1) eine Betriebsmodussteuerungseinrichtung (9) aufweist, wobei die Betriebsmodussteuerungseinrichtung (9) dazu ausgebildet ist, die Erfassungs- und/oder Auswerteeinrichtung (3, 4), den Betriebsdatenspeicher (5) und/oder die Kommunikationsschnittstelle (6) bei einer Temperatur (T) oberhalb von einem Temperaturgrenzwert (Tgrenz) in einem Normaltemperaturbetriebsmodus (NT) und bei einer Temperatur (T) gleich oder unterhalb des Temperaturgrenzwerts (Tgrenz) in einem von dem Normaltemperaturbetriebsmodus (NT) verschiedenen Tieftemperaturbetriebsmodus (TT) derart zu betreiben, dass im Tieftemperaturbetriebsmodus (TT) dem elektrochemischen Energiespeicher (8) weniger elektrische Leistung (P8) als im Normaltemperaturbetriebsmodus (NT) entnommen wird.

2. Einrichtung (1) nach Anspruch 1, wobei die Einrichtung (1) aufweist:
- den elektrochemischen Energiespeicher (8).

3. Einrichtung (1) nach einem der vorhergehenden Ansprüche,
- wobei der Temperaturgrenzwert (Tgrenz) maximal + 10 °C, insbesondere maximal 0 °C, und/oder minimal - 20 °C ist, insbesondere minimal - 10 °C ist, insbesondere - 5 °C ist.

4. Einrichtung (1) nach einem der vorhergehenden Ansprüche,
- wobei die Einrichtung (1) einen Temperatursensor (10) aufweist, wobei der Temperatursensor (10) zur Erfassung der Temperatur (T) und/oder einer von der Temperatur abhängigen Größe ausgebildet ist, und
- wobei die Betriebsmodussteuerungseinrichtung (9) dazu ausgebildet ist, die Erfassungs- und/oder Auswerteeinrichtung (3, 4), den Betriebsdatenspeicher (5) und/oder die Kommunikationsschnittstelle (6) bei Überschreitung des Temperaturgrenzwerts (Tgrenz) durch die erfasste Temperatur (T) oder eines Größengrenzwerts durch die erfasste Größe in dem Normaltemperaturbetriebsmodus (NT) und bei Erreichung oder Unterschreitung des Temperaturgrenzwerts (Tgrenz) durch die erfasste Temperatur (T) oder des Größengrenzwerts durch die erfasste Größe in dem Tieftemperaturbetriebsmodus (TT) zu betreiben.

5. Einrichtung (1) nach einem der vorhergehenden Ansprüche,
- wobei die Einrichtung (1) eine Widerstanderfassungseinrichtung (11) aufweist, wobei die Widerstanderfassungseinrichtung (11) zur Erfassung eines Widerstands (R) des elektrochemischen Energiespeichers (8) und/oder einer von dem Widerstand abhängigen Größe ausgebildet ist, und
- wobei die Betriebsmodussteuerungseinrichtung (9) dazu ausgebildet ist, die Erfassungs- und/oder Auswerteeinrichtung (3, 4), den Betriebsdatenspeicher (5) und/oder die Kommunikationsschnittstelle (6) bei Unterschreitung eines Widerstandgrenzwerts (Rgrenz) durch den erfassten Widerstand (R) oder eines Größengrenzwerts durch die erfasste Größe in dem Normaltemperaturbetriebsmodus (NT) und bei Erreichung oder Überschreitung des Widerstandgrenzwerts (Rgrenz) durch den erfassten Widerstand (R) oder des Größengrenzwerts durch die erfasste Größe in dem Tieftemperaturbetriebsmodus (TT) zu betreiben.

6. Einrichtung (1) nach Anspruch 5,
- wobei der Widerstandsgrenzwert (Rgrenz) minimal 100 Ω, insbesondere minimal 500 Ω, und/oder maximal 20 kΩ ist, insbesondere maximal 2 kΩ ist, insbesondere 1 kΩ ist.

7. Einrichtung (1) nach einem der vorhergehenden Ansprüche,
- wobei die Betriebsmodussteuerungseinrichtung (9) dazu ausgebildet ist, die Erfassungs- und/oder Auswerteeinrichtung (3, 4), den Betriebsdatenspeicher (5) und/oder die Kommunikationsschnittstelle (6) in dem Normaltemperaturbetriebsmodus (NT) periodisch in Intervallen (IT1) während einer ersten Aktivzeitdauer (twake1) zu betreiben und während einer ersten Inaktivzeitdauer (tsleep1) nicht zu betreiben und in dem Tieftemperaturmodus (TT) periodisch in Intervallen (IT2) während einer gegenüber der ersten zeitlich kürzeren zweiten Aktivdauer (twake2) zu betreiben und/oder während einer gegenüber der ersten zeitlich längeren zweiten Inaktivzeitdauer (tsleep2) nicht zu betreiben oder leistungslos zu setzen.

8. Einrichtung (1) nach Anspruch 7,
- wobei die erste Aktivzeitdauer (twake1) minimal 1 ms und/oder maximal 3 s ist, insbesondere 80 ms ist, und/oder wobei die erste Inaktivzeitdauer (tsleep1) minimal 100 ms und/oder maximal 10 s ist, insbesondere 920 ms ist, und/oder
- wobei die zweite Aktivdauer (twake2) minimal 1 ms und/oder maximal 3 s ist, insbesondere 40 ms ist, und/oder wobei die zweite Inaktivzeitdauer (tsleep2) minimal 500 ms und/oder maximal 10 s ist, insbesondere 1960 ms ist.

9. Einrichtung (1) nach Anspruch 7 oder 8,
- wobei die Betriebsmodussteuerungseinrichtung (9) dazu ausgebildet ist, bei Nicht-Erfassung einer Größe oder Betriebsdaten mittels der Erfassungs- und/oder Auswerteeinrichtung (3, 4) die erste Inaktivzeitdauer (tsleep1) auf einen maximalen Wert und/oder die zweite Inaktivzeitdauer (tsleep2) auf einen maximalen Wert zu setzen.

10. Einrichtung (1) nach einem der vorhergehenden Ansprüche,
- wobei die Einrichtung (1) einen Pufferkondensator (12) aufweist, wobei der Pufferkondensator (12) dazu ausgebildet ist, dem elektrochemischen Energiespeicher (8) elektrische Leistung (P8) zu entnehmen, und
- wobei die Erfassungs- und/oder Auswerteeinrichtung (3, 4), der Betriebsdatenspeicher (5) und/oder die Kommunikationsschnittstelle (6) dazu ausgebildet sind/ist, im Betrieb dem Pufferkondensator (12) elektrische Leistung (P3/4/5/6) zu entnehmen.

11. Einrichtung (1) nach Anspruch 10,
- wobei der Pufferkondensator (12) eine elektrische Kapazität (C) von minimal 50 µF, insbesondere von minimal 100 µF, und/oder von maximal 5000 µF, insbesondere von maximal 1000 µF aufweist, insbesondere von 470 µF aufweist, und/oder
- wobei der Pufferkondensator (12) für eine elektrische Spannung (U) von minimal 1 V und von maximal 12 V ausgebildet ist, insbesondere von 3 V ausgebildet ist.

12. Einrichtung (1) nach einem der vorhergehenden Ansprüche,
- wobei der Betriebsdatenspeicher (5) einen EEPROM-Betriebsdatenspeicher aufweist, wobei der EEPROM-Betriebsdatenspeicher (5) dazu ausgebildet ist, einzelne Bits zu löschen.

13. Einrichtung (1) nach einem der vorhergehenden Ansprüche,
- wobei die Einrichtung (1) eine Ausgabeeinrichtung (13), insbesondere eine Anzeige, aufweist, wobei die Ausgabeeinrichtung (13) dazu ausgebildet ist, einen Ein-Zustand der Einrichtung (1) auszugeben, insbesondere anzuzeigen, wobei die Ausgabeeinrichtung (13) dazu ausgebildet ist, im Betrieb dem elektrochemischen Energiespeicher (8) elektrische Leistung (P8) zu entnehmen, und
- wobei die Betriebsmodussteuerungseinrichtung (9) dazu ausgebildet ist, die Ausgabeeinrichtung (13) derart zu betreiben, dass im Tieftemperaturbetriebsmodus (TT) dem elektrochemischen Energiespeicher (8) von der Ausgabeeinrichtung (13) weniger elektrische Leistung (P8) als im Normaltemperaturbetriebsmodus (NT) entnommen wird.

14. System (50), wobei das System (50) aufweist:
- eine Einrichtung (1) nach einem der vorhergehenden Ansprüche, und
- ein motorangetriebenes Werkzeug (60).

15. System (50) nach Anspruch 14,
- wobei das motorangetriebene Werkzeug (60) ein handgeführtes, insbesondere handgetragenes oder bodengeführtes, Werkzeug ist.

## Claims

1. Device (1) for capturing operating data of a motor-driven tool (60), wherein the device (1) is designed for arrangement on the tool (60), wherein the device (1) has:
- a capture and/or evaluation device (3, 4), wherein the capture and/or evaluation device (3, 4) is designed to capture at least one quantity, wherein the quantity is dependent on an operating state of the tool (60), and to evaluate the captured quantity for the purpose of ascertaining the operating data, and/or to capture operating data,
- an operating data memory (5), wherein the operating data memory (5) is designed to store the ascertained and/or captured operating data, and/or a communication interface (6), wherein the communication interface (6) is designed to transmit the operating data wirelessly to a terminal (7),
- wherein the capture and/or evaluation device (3, 4), the operating data memory (5) and/or the communication interface (6) is/are designed to draw electric power (P8) from an electrochemical energy store (8) during operation,
**characterised in that**
- the device (1) has an operating mode control device (9), wherein the operating mode control device (9) is designed to operate the capture and/or evaluation device (3, 4), the operating data memory (5) and/or the communication interface (6) at a temperature (T) above a temperature limit value (Tlimit) in a normal temperature operating mode (NT) and at a temperature (T) equal to or below the temperature limit value (Tlimit) in a low temperature operating mode (TT), which is different from the normal temperature operating mode (NT), such that less electric power (P8) is drawn from the electrochemical energy store (8) in the low temperature operating mode (TT) than in the normal temperature operating mode (NT).

2. Device (1) according to Claim 1, wherein the device (1) has:
- the electrochemical energy store (8).

3. Device (1) according to either of the preceding claims,
- wherein the temperature limit value (Tlimit) is no more than +10°C, in particular no more than 0°C, and/or no less than -20°C, in particular is no less than -10°C, in particular is -5°C.

4. Device (1) according to one of the preceding claims,
- wherein the device (1) has a temperature sensor (10), wherein the temperature sensor (10) is designed to capture the temperature (T) and/or a quantity that is dependent on the temperature, and
- wherein the operating mode control device (9) is designed to operate the capture and/or evaluation device (3, 4), the operating data memory (5) and/or the communication interface (6) in the normal temperature operating mode (NT) when the temperature limit value (Tlimit) is exceeded by the captured temperature (T) or a quantity limit value is exceeded by the captured quantity and in the low temperature operating mode (TT) when the temperature limit value (Tlimit) is reached or not reached by the captured temperature (T) or the quantity limit value is reached or not reached by the captured quantity.

5. Device (1) according to one of the preceding claims,
- wherein the device (1) has a resistance capture device (11), wherein the resistance capture device (11) is designed to capture a resistance (R) of the electrochemical energy store (8) and/or a quantity that is dependent on the resistance, and
- wherein the operating mode control device (9) is designed to operate the capture and/or evaluation device (3, 4), the operating data memory (5) and/or the communication interface (6) in the normal temperature operating mode (NT) when a resistance limit value (Rlimit) is not reached by the captured resistance (R) or a quantity limit value is not reached by the captured quantity and in the low temperature operating mode (TT) when the resistance limit value (Rlimit) is reached or exceeded by the captured resistance (R) or the quantity limit value is reached or exceeded by the captured quantity.

6. Device (1) according to Claim 5,
- wherein the resistance limit value (Rlimit) is no less than 100 Ω, in particular no less than 500 Ω, and/or no more than 20 kΩ, in particular is no more than 2 kΩ, in particular is 1 kΩ.

7. Device (1) according to one of the preceding claims,
- wherein the operating mode control device (9) is designed to operate the capture and/or evaluation device (3, 4), the operating data memory (5) and/or the communication interface (6) in the normal temperature operating mode (NT) periodically in intervals (IT1) during a first active period (twake1) and not to operate it/them during a first inactive period (tsleep1) and to operate it/them in the low temperature mode (TT) periodically in intervals (IT2) during a second active period (twake2), which is shorter in time than the first, and/or not to operate it/them, or to render them without power, during a second inactive period (tsleep2), which is longer in time than the first.

8. Device (1) according to Claim 7,
- wherein the first active period (twake1) is no less than 1 ms and/or no more than 3 s, in particular is 80 ms, and/or wherein the first inactive period (tsleep1) is no less than 100 ms and/or no more than 10 s, in particular is 920 ms, and/or
- wherein the second active period (twake2) is no less than 1 ms and/or no more than 3 s, in particular is 40 ms, and/or wherein the second inactive period (tsleep2) is no less than 500 ms and/or no more than 10 s, in particular is 1960 ms.

9. Device (1) according to Claim 7 or 8,
- wherein the operating mode control device (9) is designed to respond to non-capture of a quantity or operating data by means of the capture and/or evaluation device (3, 4) by setting the first inactive period (tsleep1) to a maximum value and/or the second inactive period (tsleep2) to a maximum value.

10. Device (1) according to one of the preceding claims,
- wherein the device (1) has a buffer capacitor (12), wherein the buffer capacitor (12) is designed to draw electric power (P8) from the electrochemical energy store (8), and
- wherein the capture and/or evaluation device (3, 4), the operating data memory (5) and/or the communication interface (6) is/are designed to draw electric power (P3/4/5/6) from the buffer capacitor (12) during operation.

11. Device (1) according to Claim 10,
- wherein the buffer capacitor (12) has an electrical capacitance (C) of no less than 50 µF, in particular of no less than 100 µF, and/or of no more than 5000 µF, in particular of no more than 1000 µF, in particular has an electrical capacitance of 470 µF, and/or
- wherein the buffer capacitor (12) is designed for a voltage (U) of no less than 1 V and of no more than 12 V, in particular is designed for a voltage of 3 V.

12. Device (1) according to one of the preceding claims,
- wherein the operating data memory (5) has an EEPROM operating data memory, wherein the EEPROM operating data memory (5) is designed to erase individual bits.

13. Device (1) according to one of the preceding claims,
- wherein the device (1) has an output device (13), in particular a display, wherein the output device (13) is designed to output, in particular to display, an ON state of the device (1), wherein the output device (13) is designed to draw electric power (P8) from the electrochemical energy store (8) during operation, and
- wherein the operating mode control device (9) is designed to operate the output device (13) such that less electric power (P8) is drawn from the electrochemical energy store (8) by the output device (B) in the low temperature operating mode (TT) than in the normal temperature operating mode (NT) .

14. System (50), wherein the system (50) has:
- a device (1) according to one of the preceding claims, and
- a motor-driven tool (60).

15. System (50) according to Claim 14,
- wherein the motor-driven tool (60) is a manually guided, in particular hand-held or soil-guided, tool.

## Revendications

1. Dispositif (1) destiné à acquérir des données de fonctionnement d'un outil (60) à entraînement motorisé, le dispositif (1) étant configuré pour être disposé sur l'outil (60), le dispositif (1) comprenant :
- un dispositif d'acquisition et/ou d'interprétation (3, 4), le dispositif d'acquisition et/ou d'interprétation (3, 4) étant configuré pour acquérir au moins une grandeur, la grandeur étant dépendante d'un état de fonctionnement de l'outil (60), et pour interpréter la grandeur acquise en vue de déterminer les données de fonctionnement, et/ou pour acquérir des données de fonctionnement,
- une mémoire de données de fonctionnement (5), la mémoire de données de fonctionnement (5) étant configurée pour mémoriser les données de fonctionnement déterminées et/ou acquises, et/ou une interface de communication (6), l'interface de communication (6) étant configurée pour transmettre les données de fonctionnement sans fil à un terminal (7), et
- le dispositif d'acquisition et/ou d'interprétation (3, 4), la mémoire de données de fonctionnement (5) et/ou l'interface de communication (6) étant configurés pour, en fonctionnement, soutirer de la puissance électrique (P8) d'un accumulateur d'énergie électrochimique (8), **caractérisé en ce que**
- le dispositif (1) possède un dispositif de commande de mode de fonctionnement (9), le dispositif de commande de mode de fonctionnement (9) étant configuré pour faire fonctionner le dispositif d'acquisition et/ou d'interprétation (3, 4), la mémoire de données de fonctionnement (5) et/ou l'interface de communication (6) dans un mode de fonctionnement à température normale (NT) en présence d'une température (T) supérieure à une valeur limite de température (Tgrenz) et dans un mode de fonctionnement à basse température (TT), différent du mode de fonctionnement à température normale (NT), en présence d'une température (T) inférieure ou égale à la valeur limite de température (Tgrenz), de telle sorte que dans le mode de fonctionnement à basse température (TT), moins de puissance électrique (P8) est soutirée de l'accumulateur d'énergie électrochimique (8) que dans le mode de fonctionnement à température normale (NT).

2. Dispositif (1) selon la revendication 1, le dispositif (1) possédant :
- l'accumulateur d'énergie électrochimique (8).

3. Dispositif (1) selon l'une des revendications précédentes,
- la valeur limite de température (Tgrenz) étant au maximum de +10 °C, notamment au maximum de 0 °C, et/ou au minimum de -20 °C, notamment au minimum de -10 °C, notamment égale à -5 °C.

4. Dispositif (1) selon l'une des revendications précédentes,
- le dispositif (1) possédant un capteur de température (10), le capteur de température (10) étant configuré pour acquérir la température (T) et/ou une grandeur dépendante de la température, et
- le dispositif de commande de mode de fonctionnement (9) étant configuré pour faire fonctionner le dispositif d'acquisition et/ou d'interprétation (3, 4), la mémoire de données de fonctionnement (5) et/ou l'interface de communication (6) dans le mode de fonctionnement à température normale (NT) en cas de dépassement par la température (T) acquise de la valeur limite de température (Tgrenz) et dans le mode de fonctionnement à basse température (TT) dans le cas où la température (T) acquise atteint ou devient inférieure à la valeur limite de température (Tgrenz) ou la grandeur acquise atteint ou devient inférieure à la valeur limite de grandeur.

5. Dispositif (1) selon l'une des revendications précédentes,
- le dispositif (1) possédant un dispositif d'acquisition de résistance (11), le dispositif d'acquisition de résistance (11) étant configuré pour acquérir une résistance (R) de l'accumulateur d'énergie électrochimique (8) et/ou une grandeur dépendante de la résistance, et
- le dispositif de commande de mode de fonctionnement (9) étant configuré pour faire fonctionner le dispositif d'acquisition et/ou d'interprétation (3, 4), la mémoire de données de fonctionnement (5) et/ou l'interface de communication (6) dans le mode de fonctionnement à température normale (NT) en cas de dépassement par la résistance (R) acquise d'une valeur limite de résistance (Rgrenz) et dans le mode de fonctionnement à basse température (TT) dans le cas où la résistance (R) acquise atteint ou devient inférieure à la valeur limite de résistance (Rgrenz) ou la grandeur acquise atteint ou devient inférieure à la valeur limite de grandeur.

6. Dispositif (1) selon la revendication 5,
- la valeur limite de résistance (Rgrenz) étant au minimum de 100 **Ω,** notamment au minimum de 500 **Ω,** et/ou au maximum de 20 k**Ω,** notamment au maximum de 2 k**Ω,** notamment égale à 1 k**Ω.**

7. Dispositif (1) selon l'une des revendications précédentes,
- le dispositif de commande de mode de fonctionnement (9) étant configuré pour faire fonctionner le dispositif d'acquisition et/ou d'interprétation (3, 4), la mémoire de données de fonctionnement (5) et/ou l'interface de communication (6) dans le mode de fonctionnement à température normale (NT) périodiquement dans des intervalles (IT1) pendant une première durée d'activité (twake1) et ne pas les faire fonctionner pendant une première durée d'inactivité (tsleep1) et dans le mode de fonctionnement à basse température (TT) périodiquement dans des intervalles (IT2) pendant une deuxième durée d'activité (twake2), plus courte dans le temps que la première, et/ou ne pas les faire fonctionner ou les mettre hors tension pendant une deuxième durée d'inactivité (tsleep2), plus longue dans le temps que la première.

8. Dispositif (1) selon la revendication 7,
- la première durée d'activité (twake1) étant au minimum de 1 ms et/ou au maximum de 3 s, notamment égale à 80 ms, et/ou la première durée d'inactivité (tsleep1) étant au minimum de 100 ms et/ou au maximum de 10 s, notamment égale à 920 ms, et/ou
- la deuxième durée d'activité (twake2) étant au minimum de 1 ms et/ou au maximum de 3 s, notamment égale à 40 ms, et/ou la deuxième durée d'inactivité (tsleep2) étant au minimum de 500 ms et/ou au maximum de 10 s, notamment égale à 1960 ms.

9. Dispositif (1) selon la revendication 7 ou 8,
- le dispositif de commande de mode de fonctionnement (9) étant configuré pour, en cas de non-acquisition d'une grandeur ou de données de fonctionnement au moyen du dispositif d'acquisition et/ou d'interprétation (3, 4), fixer la première durée d'inactivité (tsleep1) à une valeur maximale et/ou la deuxième durée d'inactivité (tsleep2) à une valeur maximale.

10. Dispositif (1) selon l'une des revendications précédentes,
- le dispositif (1) possédant un condensateur tampon (12), le condensateur tampon (12) étant configuré pour soutirer de la puissance électrique (P8) de l'accumulateur d'énergie électrochimique (8), et
- le dispositif d'acquisition et/ou d'interprétation (3, 4), la mémoire de données de fonctionnement (5) et/ou l'interface de communication (6) étant configurés pour, en fonctionnement, soutirer de la puissance électrique (P3/4/5/6) du condensateur tampon (12).

11. Dispositif (1) selon la revendication 10,
- le condensateur tampon (12) possédant une capacité électrique (C) minimale de 50 µF, notamment minimale de 100 µF, et/ou maximale de 5000 µF, notamment maximale de 1000 µF, notamment égale à 470 µF, et/ou
- le condensateur tampon (12) étant configuré pour une tension électrique (U) minimale de 1 V et maximale de 12 V, notamment égale à 3 V.

12. Dispositif (1) selon l'une des revendications précédentes,
- la mémoire de données de fonctionnement (5) possédant une mémoire de données de fonctionnement EEPROM, la mémoire de données de fonctionnement EEPROM (5) étant configurée pour effacer des bits individuels.

13. Dispositif (1) selon l'une des revendications précédentes,
- le dispositif (1) possédant un dispositif de sortie (13), notamment un afficheur, le dispositif de sortie (13) étant configuré pour délivrer en sortie, notamment afficher, un état de marche du dispositif (1), le dispositif de sortie (13) étant configuré pour, en fonctionnement, soutirer de la puissance électrique (P8) de l'accumulateur d'énergie électrochimique (8), et
- le dispositif de commande de mode de fonctionnement (9) étant configuré pour faire fonctionner le dispositif de sortie (13) de telle sorte que dans le mode de fonctionnement à basse température (TT), moins de puissance électrique (P8) est soutirée de l'accumulateur d'énergie électrochimique (8) par le dispositif de sortie (13) que dans le mode de fonctionnement à température normale (NT).

14. Système (50), le système (50) possédant :
- un dispositif (1) selon l'une des revendications précédentes, et
- un outil (60) à entraînement motorisé.

15. Système (50) selon la revendication 14,
- l'outil (60) à entraînement motorisé étant un outil manuel, notamment portatif ou guidé au sol.
